# DEMANDE DE BREVET EUROPEEN

(11) **EP 3 442 025 A1**
(43) Date de publication de la demande: **13.02.2019**
(21) Numéro de dépôt: 18187605.3
(22) Date de dépôt: 06.08.2018
(51) Int. Cl.: H01L 27/32, G06K 9/00, H01L 27/30, G06F 3/041

(54) **SYSTÈME D'AFFICHAGE COMPRENANT UN CAPTEUR D'IMAGES**

(30) Priorité: 11.08.2017 FR 1757670
(71) Demandeur: ISORG, 38000 Grenoble (FR)
(72) Inventeur: PUSZKA, Agathe, 38000 GRENOBLE (FR); CHABLE, Quentin, 38000 GRENOBLE (FR); BOUTHINON, Benjamin, 38000 GRENOBLE (FR)
(74) Mandataire: Cabinet Beaumont

(57) **Abrégé**

L'invention concerne un système d'affichage (30) comprenant un écran d'affichage (12) comprenant des premiers et deuxièmes sous-pixels d'affichage. Chaque premier sous-pixel d'affichage (Pix) comprend un premier composant électroluminescent (LED) émettant un premier rayonnement (RL) et recouvert d'un premier filtre coloré (56) et des premières pistes conductrices (38, 44). Chaque deuxième sous-pixel d'affichage (Pix) comprend un deuxième composant électroluminescent (LED) émettant un deuxième rayonnement (RL) et recouvert d'un deuxième filtre coloré (56) et des deuxièmes pistes conductrices (38, 44). Le système d'affichage comprend, en outre, un capteur d'images (22) détectant le premier ou deuxième rayonnement ou un troisième rayonnement (RR). Les premiers sous-pixels d'affichage comprennent des premiers éléments (58) absorbant le premier rayonnement et le deuxième rayonnement et recouvrant les premières pistes conductrices. Les premiers éléments absorbants et/ou le premier filtre coloré délimitent un premier passage (60) selon la direction d'empilement pour le premier, deuxième ou troisième rayonnement.

## Description

### Domaine

La présente demande concerne un système d'affichage et de détection et plus particulièrement un système d'affichage comprenant un capteur d'image.

### Exposé de l'art antérieur

Pour certaines applications, il est souhaitable de pouvoir détecter une empreinte digitale d'un utilisateur au moyen d'un capteur d'empreintes digitales intégré à un écran d'affichage. A titre d'exemple, un écran muni d'un capteur d'empreintes digitales peut équiper des téléphones portables. Il existe des systèmes d'affichage et de détection comprenant un écran d'affichage et un capteur d'images optique qui pourraient permettre la réalisation d'un capteur d'empreintes digitales. Le brevet US 9570002 décrit un exemple d'un tel système d'affichage et de détection comprenant un écran d'affichage et un capteur d'images infrarouges.

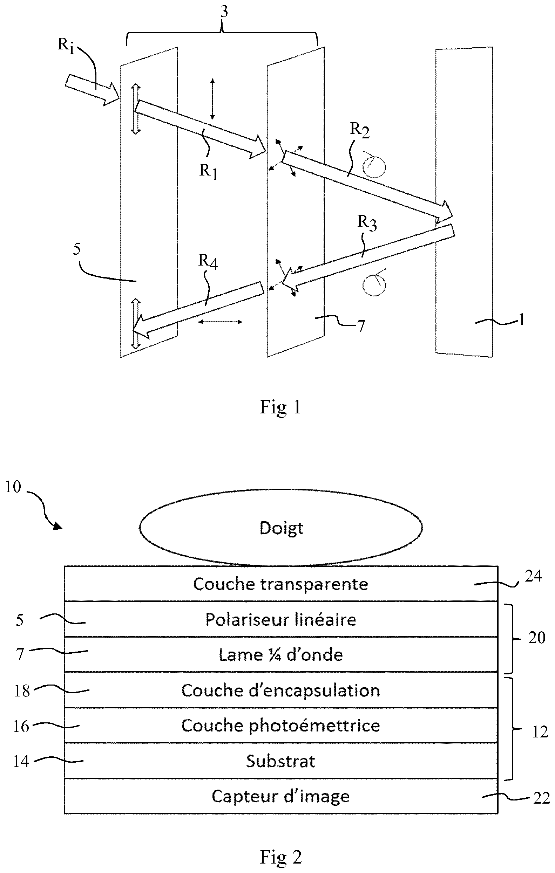

La plupart des écrans d'affichage sont partiellement réfléchissants et il est nécessaire, pour le confort de l'utilisateur, d'atténuer d'éventuels reflets. Ainsi, ces écrans d'affichage sont généralement équipés d'un système antireflet. Un exemple de système antireflet est décrit en relation avec la figure 1.

La figure 1 est une vue éclatée et simplifiée d'un écran d'affichage partiellement réfléchissant 1 recouvert d'un système antireflet 3.

Le système antireflet 3 est positionné devant l'écran d'affichage 1. Le système antireflet 3 comprend un polariseur rectiligne 5 et une lame quart d'onde 7. La lame quart d'onde 7 est positionnée entre le polariseur rectiligne 5 et l'écran d'affichage 1. Les axes de la lame quart d'onde 7 sont orientés à 45 degrés par rapport à l'axe du polariseur rectiligne 5.

Le fonctionnement du système antireflet 3 est le suivant. Un faisceau lumineux Rᵢ non polarisé incident traverse, dans un premier temps, le polariseur rectiligne 5 et devient un faisceau lumineux R₁ à polarisation rectiligne. La lame quart d'onde 7 transforme ensuite le faisceau lumineux R₁ en un faisceau lumineux R₂ à polarisation circulaire droite ou gauche. Ce faisceau R₂ est partiellement réfléchi par l'écran d'affichage 1 en un faisceau lumineux réfléchi R₃. Le faisceau lumineux réfléchi R₃ a une polarisation circulaire inverse à celle du faisceau lumineux R₂, c'est-à-dire gauche ou droite. La lame quart d'onde 7 transforme alors le faisceau lumineux R₃ en un faisceau lumineux R₄ à polarisation rectiligne. La direction de polarisation du faisceau lumineux R₄ est alors orthogonale à celle du faisceau lumineux R₁. Le polariseur 5 empêche alors le faisceau lumineux R₄ de passer.

Il serait souhaitable de pouvoir réaliser un système d'affichage équipé d'un système antireflet comprenant un capteur d'images optique, notamment pour la détection d'empreintes digitales.

### Résumé

Ainsi, un mode de réalisation prévoit un système d'affichage et de détection comprenant un écran d'affichage comprenant un empilement de couches selon une direction d'empilement et comprenant des premiers et deuxièmes sous-pixels d'affichage, chaque premier sous-pixel d'affichage comprenant un premier composant électroluminescent adapté à émettre un premier rayonnement et recouvert d'un premier filtre coloré et des premières pistes conductrices électriquement, chaque deuxième sous-pixel d'affichage comprenant un deuxième composant électroluminescent adapté à émettre un deuxième rayonnement et recouvert d'un deuxième filtre coloré et des deuxièmes pistes conductrices électriquement, le premier filtre coloré est adapté à laisser passer le premier rayonnement et à bloquer le deuxième rayonnement, le deuxième filtre coloré étant adapté à laisser passer le deuxième rayonnement et à bloquer le premier rayonnement, le système d'affichage et de détection comprenant, en outre, un capteur d'images recouvert par l'écran d'affichage et adapté à détecter le premier rayonnement, le deuxième rayonnement ou un troisième rayonnement, les premières pistes conductrices électriquement étant en un matériau absorbant le premier rayonnement et le deuxième rayonnement ou étant transparentes pour le premier rayonnement et le deuxième rayonnement ou au moins les premiers sous-pixels d'affichage comprenant des premiers éléments absorbant le premier rayonnement et le deuxième rayonnement et recouvrant les premières pistes conductrices électriquement, dans lequel, pour chaque premier sous-pixel d'affichage, les premiers éléments absorbants, le premier filtre coloré et/ou les premières pistes conductrices électriquement délimitent au moins un premier passage selon la direction d'empilement pour le premier rayonnement, le deuxième rayonnement ou le troisième rayonnement.

Selon un mode de réalisation, pour chaque premier sous-pixel d'affichage, la totalité de la surface du premier sous-pixel est recouverte par les premiers éléments absorbants et le premier filtre coloré.

Selon un mode de réalisation, le système d'affichage et de détection comprend au moins une couche diélectrique interposée entre les premiers éléments absorbants et les premières pistes conductrices électriquement.

Selon un mode de réalisation, les premiers éléments absorbants sont au contact des premières pistes conductrices électriquement.

Selon un mode de réalisation, le capteur d'images est adapté à détecter le deuxième rayonnement et les premiers éléments absorbants comprennent des troisièmes filtres colorés adaptés à laisser passer le deuxième rayonnement et à bloquer le premier rayonnement.

Selon un mode de réalisation, le capteur d'images est adapté à détecter le troisième rayonnement et les premiers éléments absorbants comprennent des quatrièmes filtres colorés adaptés à laisser passer le troisième rayonnement et à bloquer les premier et deuxième rayonnements.

Selon un mode de réalisation, les premiers éléments absorbent le troisième rayonnement.

Selon un mode de réalisation, les deuxièmes sous-pixels d'affichage comprennent des deuxièmes éléments absorbant le premier rayonnement et le deuxième rayonnement et recouvrant les deuxièmes pistes conductrices électriquement.

Selon un mode de réalisation, les deuxièmes éléments absorbants et/ou le deuxième filtre coloré délimitent au moins un deuxième passage pour le deuxième rayonnement.

Selon un mode de réalisation, le deuxième passage est recouvert d'un cinquième filtre coloré adapté à laisser passer le deuxième rayonnement.

Selon un mode de réalisation, le système d'affichage et de détection comprend, en outre, un filtre angulaire adapté à bloquer les rayons incidents dont l'incidence par rapport à une direction orthogonale à une face du filtre angulaire est supérieure à un seuil et à laisser passer au moins certains rayons incidents dont l'incidence par rapport à une direction orthogonale à la face est inférieure au seuil.

Selon un mode de réalisation, les premiers éléments absorbants forment le filtre angulaire.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1, précédemment décrite, illustre un système antireflet ;
la figure 2 est un schéma simplifié d'un système d'affichage et de détection ; et
les figures 3 à 10 sont des vues en coupe, partielles et schématiques, de modes de réalisation d'un système d'affichage et de détection comprenant un écran d'affichage et un capteur d'images.

### Description détaillée

De mêmes éléments ont été désignés par de mêmes références aux différentes figures. Par souci de clarté, seuls les éléments utiles à la compréhension des modes de réalisation décrits ont été représentés et sont détaillés.

Dans la description qui suit, lorsque l'on fait référence à des qualificatifs de position relative, tels que les termes "arrière", "haut", "bas", etc., il est fait référence à l'orientation des figures. Sauf précision contraire, l'expression "environ" signifie à 10 % près, de préférence à 5 % près.

Dans la suite de la description, on appelle lumière visible un rayonnement électromagnétique dont la longueur d'onde est comprise entre 400 nm et 700 nm et on appelle rayonnement infrarouge un rayonnement électromagnétique dont la longueur d'onde est comprise entre 700 nm et 10 µm. En outre, on entend par "élément absorbant un rayonnement" ou "élément en un matériau absorbant un rayonnement" un élément absorbant au moins 90 %, de préférence au moins 95 %, dudit rayonnement.

Un pixel d'une image correspond à l'élément unitaire de l'image affichée par un écran d'affichage. Lorsque l'écran d'affichage est un écran d'affichage d'images couleur, il comprend en général pour l'affichage de chaque pixel de l'image au moins trois composants d'émission et/ou de régulation de l'intensité lumineuse, également appelés sous-pixels d'affichage, qui émettent chacun un rayonnement lumineux sensiblement dans une seule couleur (par exemple, le rouge, le vert ou le bleu). La superposition des rayonnements émis par ces trois sous-pixels d'affichage fournit à l'observateur la sensation colorée correspondant au pixel de l'image affichée. On appelle dans ce cas pixel d'affichage de l'écran d'affichage l'ensemble formé par les trois sous-pixels d'affichage utilisés pour l'affichage d'un pixel d'une image.

La figure 2 est un schéma simplifié d'un système d'affichage et de détection 10 adapté à afficher une image et à détecter une image, par exemple une empreinte digitale.

Le système d'affichage et de détection 10 comprend un écran d'affichage 12. L'écran d'affichage 12 est par exemple constitué d'un empilement comprenant successivement :
- un substrat transparent ou partiellement transparent 14 par exemple en un polymère ou en verre ;
- une couche photoémettrice 16 reposant sur le substrat 14 et en contact avec celui-ci ; et
- une couche d'encapsulation transparente ou partiellement transparente 18, par exemple en un polymère, une couche inorganique (SiNₓ, SiOₓ, Al₂O₃) ou un multicouche de couches organiques et inorganiques, reposant sur la couche photoémettrice 16 et en contact avec celle-ci.

Le substrat 14 et la couche d'encapsulation 18 sont transparents ou partiellement transparents à la lumière visible et aux infrarouges.

La couche photoémettrice 16 comprend une matrice de pixels d'affichage. Chaque pixel d'affichage comprend un composant optoélectronique adapté à émettre un rayonnement électromagnétique, appelé aussi composant électroluminescent. Chaque composant électroluminescent correspond par exemple à une diode électroluminescente, notamment à une diode électroluminescente organique (OLED, de l'anglais Organic Light-Emitting Diode). Les pixels d'affichage peuvent, en outre, comprendre des pistes conductrices électriquement et des éléments de commutation, notamment des transistors, non représentés, permettant la sélection des pixels d'affichage.

Le système d'affichage et de détection 10 comprend en outre un système antireflet 20 du type de celui décrit en relation avec la figure 1. On y retrouve le polariseur rectiligne 5 et la lame quart d'onde 7. Le système antireflet 20 est disposé sur et en contact avec l'écran d'affichage 12, c'est-à-dire que la lame quart d'onde 7 repose sur et en contact avec la couche d'encapsulation 18 de l'écran d'affichage 12.

Le système d'affichage et de détection 10 comprend en outre un capteur d'images 22. A titre d'exemple, le capteur d'images 22 est situé sous l'écran d'affichage 12, c'est-à-dire que le substrat 14 de l'écran d'affichage 12 repose sur et en contact avec le capteur d'images 22. Le capteur d'images 22 comprend une matrice de capteurs de photons, ou photodétecteurs. Les photodétecteurs sont disposés de façon qu'un rayonnement incident les atteigne après avoir traversé l'écran d'affichage 12. A titre d'exemple, les photodétecteurs sont positionnés au niveau des interstices entre les composants électroluminescents de la couche photoémettrice 16 afin de recevoir un rayonnement lumineux passant au travers de l'écran d'affichage. Les photodétecteurs peuvent être recouverts d'un revêtement de protection transparent, non représenté. Le capteur d'images 22 comprend, en outre, des pistes conductrices et des éléments de commutation, notamment des transistors, non représentés, permettant la sélection des photodétecteurs. Les photodétecteurs peuvent être réalisés en matériaux organiques. Les photodétecteurs peuvent correspondre à des photodiodes organiques (OPD, de l'anglais Organic Photodiode) ou à des photorésistances organiques. Le système d'affichage et de détection 10 comprend, en outre, des moyens non représentés de traitement des signaux fournis par le capteur d'images 22, comprenant par exemple un microprocesseur, et des moyens non représentés de commande de l'écran d'affichage 12.

A titre d'exemple, le capteur d'images 22 peut être utilisé pour détecter l'empreinte digitale d'au moins un doigt d'un utilisateur. De préférence, le capteur d'images 22 peut être utilisé pour détecter simultanément les empreintes digitales de plusieurs doigts de l'utilisateur. Selon un mode de réalisation, le capteur d'images 22 peut jouer le rôle d'une surface tactile, dans lequel la localisation d'un objet ou organe sur le système d'affichage et de détection 10 est déterminée par les photodétecteurs. Le système d'affichage et de détection 10 peut alors être utilisé comme interface utilisateur interactive contrôlable par simple glissement du doigt ou de la main sur la surface tactile. Une telle interface utilisateur interactive peut être utilisée notamment pour commander des téléphones mobiles, des ordinateurs, des postes de télévision, des véhicules automobiles, des billetteries automatiques, des équipements industriels, des équipements médicaux, etc.

Le système d'affichage et de détection 10 comprend en outre un revêtement de protection 24 transparent reposant sur et en contact avec le système antireflet 20. Ce revêtement est transparent à la lumière visible et aux infrarouges. Le revêtement de protection 24 est par exemple une lame de verre ou une couche transparente en un polymère.

Selon un premier mode de fonctionnement, un objet ou organe, par exemple un doigt, peut être éclairé par une source externe au système d'affichage et de détection qui émet un rayonnement qui traverse ou est réfléchi par l'objet ou organe. L'objet ou organe émet alors un rayonnement lumineux non polarisé en direction des photodétecteurs du capteur d'images 22. Ce rayonnement non polarisé traverse le polariseur 5 et 50 % de son intensité est perdue.

Selon un deuxième mode de fonctionnement, l'objet ou l'organe n'est pas éclairé par une source externe. Il est alors éclairé par un rayonnement lumineux non polarisé émis par la couche photoémettrice 16 de l'écran d'affichage 12. Le rayonnement lumineux se polarise et perd une partie de son intensité en traversant le polarisateur 5. Ce rayonnement lumineux se reflète sur l'objet ou l'organe et est réfléchi. Ce rayonnement réfléchi traverse le polariseur 5 et perd à nouveau une partie de son intensité.

Ainsi, un inconvénient de ce système d'affichage et de détection 10 est que le polariseur 5 du système antireflet 20 diminue la luminosité de l'image de l'objet ou organe sur le capteur d'images 22.

Les inventeurs ont mis en évidence que la majorité des reflets observés par un utilisateur proviennent de la réflexion d'un rayonnement extérieur sur les éléments métalliques du système d'affichage et de détection 10, notamment les pistes métalliques de commande des composants électroluminescents de l'écran d'affichage 12 ou l'électrode sur laquelle est formée la région active du composant électroluminescent de l'écran d'affichage 12. Les inventeurs ont par ailleurs montré que la couche du polariseur utilisé comme couche d'antireflet rendait difficile la détection d'empreintes digitales car le signal renvoyé par les doigts est fortement atténué. Il existe donc un besoin de trouver une alternative permettant à la fois de garantir une fonction antireflet et de laisser passer le signal utile pour le capteur d'images, notamment pour la détection d'empreinte digitale.

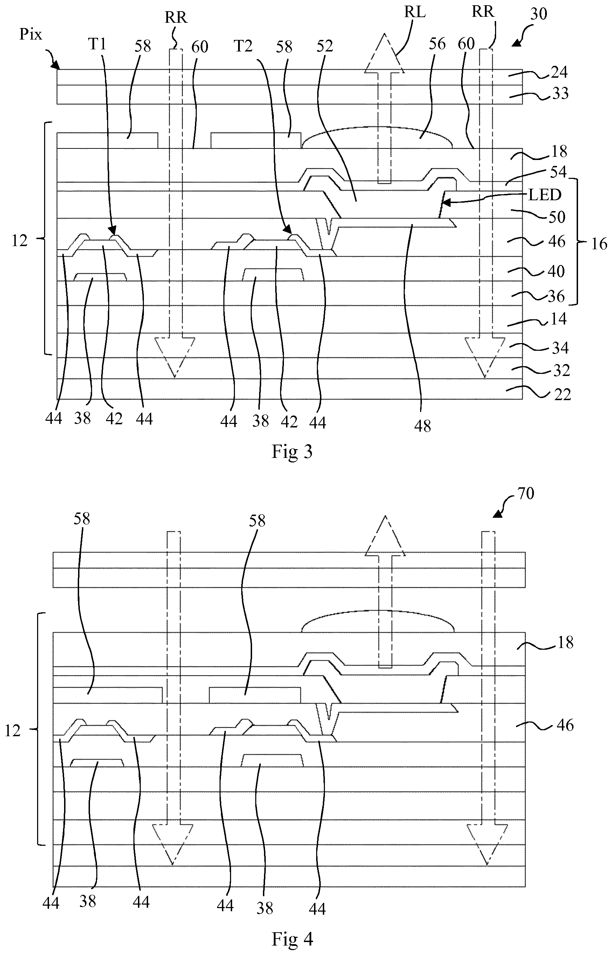

La figure 3 est une vue en coupe, partielle et schématique, d'un mode de réalisation d'un système d'affichage et de détection 30 adapté à détecter une image, par exemple une empreinte digitale.

Le système d'affichage et de détection 30 comprend l'ensemble des éléments du système d'affichage et de détection 10 représenté en figure 2 à la différence que le système antireflet 20 n'est pas présent.

En figure 3 sont en outre représentées :
- une couche adhésive 32 entre le capteur d'images 22 et l'écran d'affichage 12 ;
- une couche adhésive 33 entre la couche transparente 24 et l'écran d'affichage 12 ; et
- une couche d'encapsulation arrière 34 de l'écran d'affichage 12 recouvrant la face du substrat 14 située du côté du capteur d'images 22.

Une surface tactile, également appelée panneau tactile, non représentée, peut être prévue entre l'écran d'affichage 12 et la couche transparente 24.

La couche d'encapsulation arrière 34 peut correspondre à une couche de poly(téréphtalate d'éthylène) (PET) ayant, par exemple, une épaisseur de l'ordre de 100 µm. Le substrat 14 peut correspondre à une couche de polyamide ayant, par exemple, une épaisseur de l'ordre de 10 µm.

Sur la figure 3 et les figures suivantes, les couches 24 et 33 sont représentées à distance de l'écran d'affichage 12 alors, qu'en réalité, la couche 33 est en contact avec l'écran d'affichage 12.

En figure 3, on a représenté schématiquement un sous-pixel d'affichage Pix comprenant une diode électroluminescente LED et deux transistors à effet de champ T1 et T2. Les transistors T1 et T2 peuvent être des transistors organiques ou inorganiques, par exemple des transistors à base de silicium amorphe aSi, à base d'oxyde métallique, notamment de l'oxyde de zinc-gallium-indium (IGZO), ou à base de silicium polycristallin, notamment du silicium polycristallin à basse température (LTPS).

La couche photoémettrice 16 de l'écran d'affichage 12 comporte, pour chaque sous-pixel d'affichage Pix, un empilement de couches comprenant, du bas vers le haut en figure 3 :
une couche d'interface 36, également appelée couche tampon, reposant sur le substrat 14 et en contact avec le substrat 14 ;
des pistes conductrices électriquement 38, par exemple métalliques, formant les grilles des transistors T1 et T2 ;
une couche diélectrique 40 recouvrant les pistes conductrices 38 et les parties de la couche d'interface 36 non recouvertes par les pistes conductrices 38 ;
des régions 42 semiconductrices organiques ou inorganiques, notamment à base de silicium amorphe aSi, à base d'oxyde métallique, notamment du IGZO, ou à base de silicium polycristallin, notamment du LTPS, reposant sur la couche diélectrique 40 dans lesquelles se forment les régions de canal des transistors T1 et T2, les portions de la couche diélectrique 40 interposées entre les pistes conductrices 38 et les régions semiconductrices 42 formant les isolants de grille des transistors T1 et T2 ;
des pistes conductrices électriquement 44 reposant sur la couche diélectrique 40, en contact de la région 42 et formant notamment les contacts de source et de drain des transistors T1 et T2 ;
une couche diélectrique 46 recouvrant les transistors T1 et T2 et la couche diélectrique 40 à côté des transistors T1 et T2 ;
une électrode 48 de la diode électroluminescente LED s'étendant sur la couche diélectrique 46 et s'étendant au travers de la couche diélectrique 46 pour venir au contact de l'une des pistes conductrices 44, l'électrode 48 jouant par exemple le rôle d'anode ;
une couche diélectrique 50 recouvrant la couche diélectrique 46 et ne recouvrant pas ou seulement partiellement l'électrode 48 et permettant d'isoler les diodes électroluminescentes les unes des autres ;
une région active 52 de la diode électroluminescente LED adaptée à émettre un rayonnement et reposant sur l'électrode 48 et au contact de l'électrode 48 au travers de la couche diélectrique 50 ; et
une couche 54 électriquement conductrice et partiellement transparente au rayonnement émis par la région active 52, par exemple transparente à 50 %, afin de créer une cavité optique et partiellement transparente au rayonnement détecté par le capteur d'images 22 et recouvrant la couche diélectrique 50 et la région active 52 et au contact de la région active 52.

La couche d'encapsulation 18 repose sur la couche 54 conductrice et partiellement transparente.

Dans le présent mode de réalisation, l'écran d'affichage 12 comprend, en outre, un filtre coloré 56 reposant sur la couche d'encapsulation 18 en regard de la région active 52, selon la direction d'empilement des couches de l'écran d'affichage 12, et des éléments 58 absorbants, également appelés matrice noire, pour le rayonnement détecté par le capteur d'images 22 et pour le rayonnement détectable par un observateur et reposant sur la couche d'encapsulation 18 en regard des transistors T1 et T2 et des pistes conductrices 44 selon la direction d'empilement de couches de l'écran d'affichage 12. Des zones 60 de la couche d'encapsulation 18 ne sont recouvertes ni par le filtre coloré 56 ni par les éléments absorbants 58. Les zones 60 sont délimitées latéralement par les éléments absorbants 58 et/ou le filtre coloré 56. Ces zones 60 ne sont pas en regard selon la direction d'empilement des couches de l'écran d'affichage 12 de pistes conductrices 38 et 44. Le filtre coloré 56 peut être en résine coloré et les éléments absorbants 58 peuvent être en résine noire ou en résine teintée, par exemple en résine SU-8 noire. Selon un mode de réalisation, les photodétecteurs du capteur d'images 22 peuvent être disposés en regard des zones 60 selon la direction d'empilement de l'écran d'affichage 12.

Dans le présent mode de réalisation, la transmittance du filtre coloré 56 est proche du spectre d'émission de la région active 52 de la diode électroluminescente LED. Ceci signifie que le filtre coloré 56 laisse passer sensiblement complètement la lumière émise par la région active 52 de la diode électroluminescente LED et bloque les autres longueurs d'onde.

Le rayonnement RL émis par la région active 52 de la diode électroluminescente LED traverse le filtre coloré 56 recouvrant le composant électroluminescent LED. La transmittance du filtre coloré 56 étant proche du spectre d'émission de la diode électroluminescente LED, le rayonnement RL émis par la région active 52 n'est sensiblement pas atténué par le filtre coloré 56.

En présence d'un objet devant la couche transparente 24, le rayonnement RL est au moins en partie réfléchi par l'objet, non représenté, par exemple le doigt d'un utilisateur. Le rayonnement réfléchi RR est absorbé par les éléments absorbants 58 sauf au niveau des zones 60 où le rayonnement réfléchi RR progresse jusqu'à atteindre le capteur d'images 22. Comme il n'y a pas de système antireflet 20 comprenant un polariseur et une lame quart d'onde, l'atténuation du rayonnement réfléchi RR, au cours de sa progression jusqu'au capteur d'images 22, est réduite.

Le rayonnement extérieur qui atteint la couche transparente 24 est absorbé par les éléments absorbants 58 sans se réfléchir sur les pistes conductrices 38, 44 recouvertes par ces éléments 58. En outre, le rayonnement extérieur qui passe à travers les zones 60 n'est pas ou peu réfléchi. On obtient donc une fonction antireflet. Le rayonnement extérieur qui atteint le filtre coloré 56 peut se réfléchir notamment sur l'électrode 48. Toutefois, étant donné que ce rayonnement est filtré par le filtre coloré 56, l'intensité du rayonnement réfléchi vers un observateur est réduite.

La figure 4 est une vue en coupe analogue à la figure 3 d'un autre mode de réalisation d'un système d'affichage et de détection 70. Le système d'affichage et de détection 70 comprend l'ensemble des éléments du système d'affichage et de détection 30 représenté en figure 3 à la différence que les éléments absorbants 58 ne reposent pas sur la couche d'encapsulation 18 mais sur la couche diélectrique 46 en regard des pistes conductrices 38, 44 selon la direction d'empilement de l'écran d'affichage 12.

A titre de variante, les éléments absorbants 58 peuvent être déposés directement sur les pistes conductrices 38, 44. De façon générale, les éléments absorbants 58 peuvent être déposés en regard des pistes conductrices 38, 44 selon la direction d'empilement des couches de l'écran d'affichage 12 à n'importe quel niveau entre la couche transparente 24 et les pistes conductrices 38, 44.

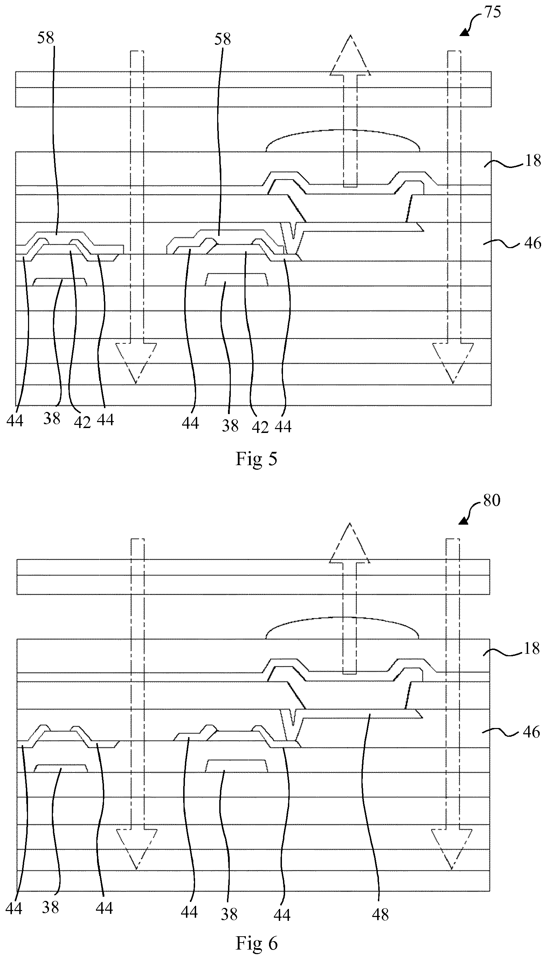

La figure 5 est une vue en coupe analogue à la figure 3 d'un autre mode de réalisation d'un système d'affichage et de détection 75. Le système d'affichage et de détection 75 comprend l'ensemble des éléments du système d'affichage et de détection 30 représenté en figure 3 à la différence que les éléments absorbants 58 ne reposent pas sur la couche d'encapsulation 18 mais directement sur les pistes conductrices 44 et les régions actives 42.

La figure 6 est une vue en coupe analogue à la figure 3 d'un autre mode de réalisation d'un système d'affichage et de détection 80. Le système d'affichage et de détection 80 comprend l'ensemble des éléments du système d'affichage et de détection 30 représenté en figure 3 à la différence que les éléments absorbants 58 ne sont pas présents et que les pistes conductrices 38, 44, et éventuellement l'électrode 48, sont en un matériau conducteur électriquement et absorbant dans le domaine visible, par exemple en chrome (Cr), nickel (Ni), aluminium (Al), en un matériau transparent dans le domaine visible comme les oxydes métalliques, par exemple l'oxyde d'indium-étain (ITO), ou en un métal transparent dans le domaine visible lorsqu'il est déposé suffisamment fin, par exemple avec une épaisseur inférieure à 100 nm.

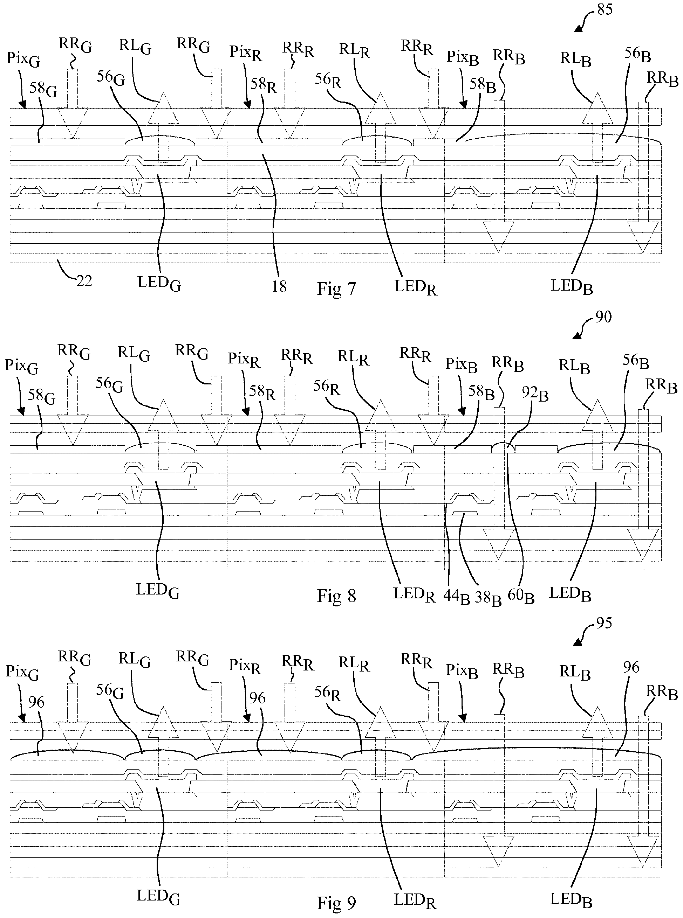

La figure 7 est une vue en coupe d'un autre mode de réalisation d'un système d'affichage et de détection 85. En figure 7, trois sous-pixels d'affichage sont représentés, par exemple un sous-pixel d'affichage Pix_{G} émettant de la lumière verte, un sous-pixel d'affichage Pix_{R} émettant de la lumière rouge et un sous-pixel d'affichage Pix_{B} émettant de la lumière bleue. Toutefois, la description qui suit s'applique également dans le cas où le pixel Pix_{B} émet de la lumière de n'importe quelle couleur, par exemple de la lumière rouge ou de la lumière verte.

Dans la suite de la description, on ajoute le suffixe G, R ou B à une référence pour indiquer que l'élément désigné par la référence fait partie respectivement du sous-pixel d'affichage Pix_{G}, Pix_{R} ou Pix_{B}.

Dans le présent mode de réalisation, chaque sous-pixel d'affichage Pix_{G} et Pix_{R} a la structure représentée en figure 3 à la différence que les éléments absorbants 58_{G} et 58_{R} recouvrent en totalité la couche d'encapsulation 18 autour du filtre coloré 56_{G} et 56_{R}. Le sous-pixel d'affichage Pix_{B} a la structure représentée en figure 3 à la différence que le filtre coloré 56_{B} s'étend en vue de dessus sur une surface plus importante que celle occupée par la diode électroluminescente LED_{G}, par exemple sensiblement sur plus de 80 % de la surface du sous-pixel d'affichage Pix_{B}, de préférence sur plus de 90 % de la surface du sous-pixel d'affichage Pix_{B}, les éléments opaque 58_{B} recouvrant moins de 20 % de la surface du sous-pixel d'affichage Pix_{B}, de préférence moins de 10 % de la surface du sous-pixel d'affichage Pix_{B}.

Pour les sous-pixels d'affichage Pix_{G} et Pix_{R}, le rayonnement RL_{G} et RL_{R} émis par la diode électroluminescente LED_{G} et LED_{R} se propage au travers du filtre coloré 56_{G} et 56_{R}. Pour les sous-pixels d'affichage Pix_{G} et Pix_{R}, le rayonnement réfléchi RR_{G} et RR_{B} est bloqué par les éléments absorbants 58_{G} et 58_{R}. Pour le sous-pixel d'affichage Pix_{B}, le rayonnement RL_{B} émis par la diode électroluminescente LED_{B} se propage au travers du filtre coloré 56_{B}. Le rayonnement réfléchi RR_{B} se propage au travers du filtre coloré 56_{B} jusqu'au capteur d'images 22. On obtient ainsi un filtrage en longueur d'onde du rayonnement qui atteint le capteur d'images 22. Les inventeurs ont mis en évidence que, pour une application pour la détection d'empreintes digitales, un plus fort contraste de l'image de l'empreinte digitale peut être obtenu lorsque la plage de longueurs d'ondes du rayonnement atteignant le capteur 22 est réduite, notamment lorsque le rayonnement atteignant le capteur 22 est de couleur bleue.

La figure 8 est une vue en coupe d'un autre mode de réalisation d'un système d'affichage et de détection 90. Les sous-pixels d'affichage Pix_{G} et Pix_{R} du système d'affichage et de détection 90 sont identiques aux sous-pixels d'affichage Pix_{G} et Pix_{R} du système d'affichage et de détection 85. Le sous-pixel d'affichage Pix_{B} du système d'affichage et de détection 90 comprend l'ensemble des éléments du sous-pixel d'affichage Pix du système d'affichage et de détection 30 représenté en figure 3 et comprend, en outre, au moins un filtre coloré supplémentaire 92_{B} sur la région 60_{B} non recouverte par les éléments absorbants 58_{B}. De préférence, le filtre coloré supplémentaire 92_{B} a la même composition que le filtre coloré 56_{B}. L'écran d'affichage 12 du système d'affichage et de détection 90 a un contraste augmenté par rapport au système d'affichage et de détection 85 représenté en figure 7 dans la mesure où les réflexions sur les pistes conductrices 38B et 44B sont supprimées.

La figure 9 est une vue en coupe d'un autre mode de réalisation d'un système d'affichage et de détection 95. Le système d'affichage et de détection 95 comprend l'ensemble des éléments du système d'affichage et de détection 85 à la différence que les éléments absorbants 58_{G}, 58_{R} et 58_{B} et le filtre coloré 56_{B} sont remplacés par un filtre coloré 96 ayant les mêmes propriétés de filtrage que le filtre coloré 56_{B}. Pour les sous-pixels d'affichage Pix_{G} et Pix_{R}, le rayonnement réfléchi RR_{G} et RR_{B} est bloqué par le filtre coloré 96 tandis que pour le sous-pixel d'affichage Pix_{B}, le rayonnement réfléchi RR_{B} se propage au travers du filtre coloré 96. A titre de variante, le système d'affichage et de détection 95 comprend, en outre, des éléments absorbants, analogues aux éléments absorbants 58_{G}, 58_{R} et 58_{B}, en regard des pistes métalliques selon la direction d'empilement de l'écran d'affichage 12 qui peuvent être situés à n'importe quel niveau entre la couche transparente 24 et les pistes conductrices 38, 44. Ceci permet d'améliorer encore plus l'effet antireflet.

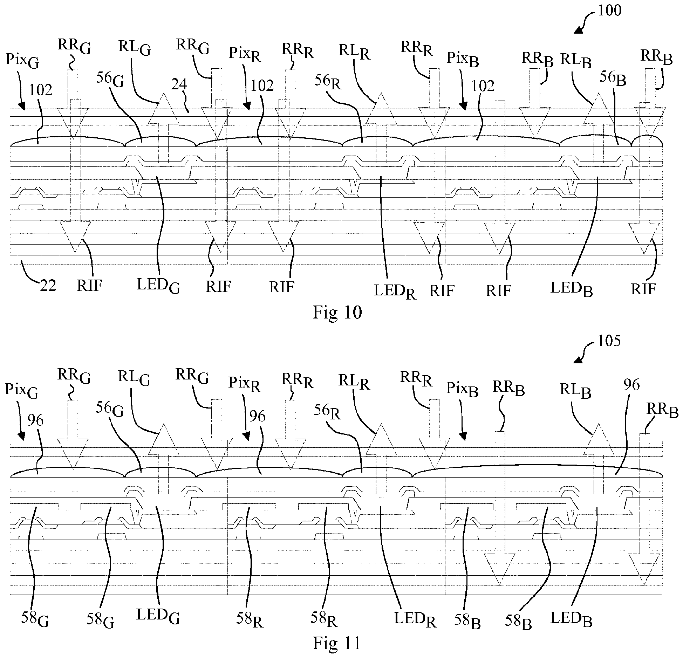

La figure 10 est une vue en coupe d'un autre mode de réalisation d'un système d'affichage et de détection 100. Le système d'affichage et de détection 100 comprend l'ensemble des éléments du système d'affichage et de détection 85 à la différence que les éléments absorbants 58_{G}, 58_{R} et 58_{B} sont remplacés par un filtre coloré 102 adapté à laisser passer un rayonnement RIF dans une plage de longueurs d'ondes différentes des plages de longueurs des rayonnements émis par les diodes électroluminescentes LED_{G}, LED_{R} et LED_{B}, par exemple dans l'infrarouge ou le proche infrarouge. A titre de variante, le système d'affichage et de détection 100 comprend, en outre, des éléments absorbants, analogues aux éléments absorbants 58_{G}, 58_{R} et 58_{B}, en regard des pistes métalliques selon la direction d'empilement de l'écran d'affichage 12 qui peuvent être situés à n'importe quel niveau entre la couche transparente 24 et les pistes conductrices 38, 44. Ceci permet d'améliorer encore plus l'effet antireflet.

Dans le présent mode de réalisation, le système d'affichage et de détection 100 peut comprendre une source lumineuse, non représentée, adaptée à émettre un rayonnement lumineux dans la couche 24 qui joue alors le rôle d'un guide d'ondes. Le rayonnement émis par la source peut être un rayonnement visible et/ou un rayonnement infrarouge et est dans une plage de longueurs d'onde détectée par le capteur d'images 22. Le rayonnement est injecté dans la couche 24 depuis la périphérie de la couche 24, par exemple depuis un bord latéral de la couche 24. Ce rayonnement peut être réfléchi partiellement lorsqu'un objet, par exemple un doigt est posé sur la couche 24, le rayonnement réfléchi étant détecté par le capteur d'images 22.

La figure 11 est une vue en coupe d'un autre mode de réalisation d'un système d'affichage et de détection 105. Le système d'affichage et de détection 105 comprend l'ensemble des éléments du système d'affichage et de détection 95, chaque sous-pixel d'affichage Pix_{G}, Pix_{R} et Pix_{B} comprenant en outre les éléments absorbants 58G, 58_{R} et 58_{B} du mode de réalisation de sous-pixel d'affichage Pix représenté sur la figure 4.

Des modes de réalisation particuliers ont été décrits. Diverses variantes et modifications apparaissent à l'homme de l'art. De plus, le système d'affichage et de détection peut en outre comprendre un filtre angulaire disposé entre l'écran d'affichage 12 et le capteur d'images 22. Le filtre angulaire est adapté à filtrer le rayonnement incident en fonction de l'incidence du rayonnement par rapport à la face supérieure du filtre angulaire, notamment pour que le capteur d'images 22 reçoive seulement les rayons dont l'incidence par rapport à un axe perpendiculaire à la face supérieure du filtre angulaire est inférieure à un angle d'incidence maximale inférieur à 45°, de préférence inférieur à 30°, plus préférentiellement inférieur à 20°, encore plus préférentiellement inférieur à 10°. Le filtre angulaire est adapté à bloquer les rayons du rayonnement indicent dont l'incidence par rapport à un axe perpendiculaire à la face supérieure du filtre angulaire est supérieure à l'angle d'incidence maximale. Le filtre angulaire peut comprendre une matrice de trous délimités par des murs opaques audit rayonnement. Selon un autre mode de réalisation, les éléments absorbants 58 peuvent jouer le rôle de filtre angulaire. Dans ce cas, les passages 60, 60B forment les trous du filtre angulaire. La hauteur h des trous, mesurée selon la direction d'empilement de l'écran d'affichage 12, peut varier de 1 µm à 1 mm, de préférence de 20 µm à 100 µm. La largeur w des trous, mesurée selon la direction d'empilement de l'écran d'affichage 12, peut varier de 5 µm à 30 µm, par exemple environ 10 µm. Le rapport h/w peut varier de 1 à 10. Le pas p peut varier de 10 µm à 30 µm, par exemple environ 15 µm.

On note que l'homme de l'art peut combiner divers éléments de ces divers modes de réalisation et variantes sans faire preuve d'activité inventive. En particulier, les éléments absorbants 58 décrits en relation avec les figures 5 et 6 peuvent être mis en oeuvre avec les systèmes d'affichage et de détection 85, 95, 100 ou 105 représentés respectivement sur les figures 7, 9, 10 et 11.

## Revendications

1. Système d'affichage et de détection (30 ; 70 ; 75 ; 80 ; 85 ; 90 ; 95 ; 100 ; 105) comprenant un écran d'affichage (12) comprenant un empilement de couches selon une direction d'empilement et comprenant des premiers et deuxièmes sous-pixels d'affichage, chaque premier sous-pixel d'affichage (Pix ; Pix_{R}, Pix_{G}) comprenant un premier composant électroluminescent (LED ; LED_{R}, LED_{G}) adapté à émettre un premier rayonnement (RL ; RL_{R}, RL_{G}) et recouvert d'un premier filtre coloré (56 ; 56_{R}, 56_{G}) et des premières pistes conductrices électriquement (38, 44 ; 38_{R}, 44_{R}, 38_{G}, 44_{G}), chaque deuxième sous-pixel d'affichage (Pix ; Pix_{B}) comprenant un deuxième composant électroluminescent (LED ; LED_{B}) adapté à émettre un deuxième rayonnement (RL ; RL_{B}) et recouvert d'un deuxième filtre coloré (56 ; 56_{B}) et des deuxièmes pistes conductrices électriquement (38, 44 ; 38_{B}, 44_{B}), le premier filtre coloré (56 ; 56_{R}, 56_{G}) étant adapté à laisser passer le premier rayonnement et à bloquer le deuxième rayonnement, le deuxième filtre coloré (56 ; 56_{B}) étant adapté à laisser passer le deuxième rayonnement et à bloquer le premier rayonnement, le système d'affichage et de détection comprenant, en outre, un capteur d'images (22) recouvert par l'écran d'affichage et adapté à détecter le premier rayonnement, le deuxième rayonnement ou un troisième rayonnement (RR ; RIF),
dans lequel :
les premières pistes conductrices électriquement sont en un matériau absorbant le premier rayonnement et le deuxième rayonnement ; ou
les premières pistes conductrices électriquement sont transparentes pour le premier rayonnement et le deuxième rayonnement ; ou
au moins les premiers sous-pixels d'affichage comprennent des premiers éléments (58 ; 58_{R}, 58_{G}; 96 ; 102) absorbant le premier rayonnement et le deuxième rayonnement et recouvrant les premières pistes conductrices électriquement, et
dans lequel, pour chaque premier sous-pixel d'affichage, les premiers éléments absorbants, le premier filtre coloré et/ou les premières pistes conductrices électriquement délimitent au moins un premier passage (60 ; 60_{B}) selon la direction d'empilement pour le premier rayonnement, le deuxième rayonnement ou le troisième rayonnement.

2. Système d'affichage et de détection selon la revendication 1, dans lequel, pour chaque premier sous-pixel d'affichage (Pix ; Pix_{R}, Pix_{G}), la totalité de la surface du premier sous-pixel est recouverte par les premiers éléments absorbants (58 ; 58_{R}, 58_{G}, 58_{B} ; 96 ; 102) et le premier filtre coloré (56 ; 56_{B}).

3. Système d'affichage et de détection selon la revendication 1 ou 2, comprenant au moins une couche diélectrique (18, 46) interposée entre les premiers éléments absorbants (58 ; 58_{R}, 58_{G}; 96 ; 102) et les premières pistes conductrices électriquement (38, 44 ; 38_{B}, 44_{B}).

4. Système d'affichage et de détection selon l'une quelconque des revendications 1 à 3, dans lequel les premiers éléments absorbants (58 ; 58_{R}, 58_{G}) sont au contact des premières pistes conductrices électriquement (38, 44 ; 38_{B}, 44_{B}).

5. Système d'affichage et de détection selon l'une quelconque des revendications 1 à 4, dans lequel le capteur d'images (22) est adapté à détecter le deuxième rayonnement et dans lequel les premiers éléments absorbants comprennent des troisièmes filtres colorés (96) adaptés à laisser passer le deuxième rayonnement (RL ; RL_{B}) et à bloquer le premier rayonnement (RL ; RL_{R}, RL_{G}).

6. Système d'affichage et de détection selon l'une quelconque des revendications 1 à 5, dans lequel le capteur d'images (22) est adapté à détecter le troisième rayonnement (RR ; RRB; RIF) et dans lequel les premiers éléments absorbants comprennent des quatrièmes filtres colorés (102) adaptés à laisser passer le troisième rayonnement (RL ; RL_{B}) et à bloquer les premier et deuxième rayonnements (RL ; RL_{R}, RL_{G}, RL_{B}).

7. Système d'affichage et de détection selon la revendication 6, dans lequel les premiers éléments (58 ; 58_{R}, 58_{G}, 58_{B} ; 96) absorbent le troisième rayonnement.

8. Système d'affichage et de détection selon l'une quelconque des revendications 1 à 7, dans lequel les deuxièmes sous-pixels d'affichage (Pix_{B}) comprennent des deuxièmes éléments (58_{B}) absorbant le premier rayonnement et le deuxième rayonnement et recouvrant les deuxièmes pistes conductrices électriquement (38_{B}, 44_{B}).

9. Système d'affichage et de détection selon la revendication 8, dans lequel les deuxièmes éléments absorbants (58_{B}) et/ou le deuxième filtre coloré (56_{B}) délimitent au moins un deuxième passage (60_{B}) pour le deuxième rayonnement.

10. Système d'affichage et de détection selon la revendication 9, dans lequel le deuxième passage (60_{B}) est recouvert d'un cinquième filtre coloré (92_{B}) adapté à laisser passer le deuxième rayonnement.

11. Système d'affichage et de détection selon l'une quelconque des revendications 1 à 10, comprenant, en outre, un filtre angulaire adapté à bloquer les rayons incidents dont l'incidence par rapport à une direction orthogonale à une face du filtre angulaire est supérieure à un seuil et à laisser passer au moins certains rayons incidents dont l'incidence par rapport à une direction orthogonale à la face est inférieure au seuil.

12. Système d'affichage et de détection selon la revendication 11, dans lequel les premiers éléments absorbants (58 ; 58_{R}, 58_{G}, 58_{B} ; 96 ; 102) forment le filtre angulaire.
